# EUROPEAN PATENT APPLICATION

(11) **EP 2 194 169 A1**
(43) Date of publication of application: **09.06.2010**
(21) Application number: 08834769.5
(22) Date of filing: 19.09.2008
(51) Int. Cl.: C30B 29/38, C30B 19/04

(54) **METHOD FOR GROWING GROUP III NITRIDE CRYSTAL**

(30) Priority: 05.10.2007 JP 2007262107
(71) Applicant: Sumitomo Electric Industries, Ltd., Osaka-shi, Osaka 541-0041 (JP)
(72) Inventor: UEMATSU, Koji, Itami-shi Hyogo 664-0016 (JP); YOSHIDA, Hiroaki, Itami-shi Hyogo 664-0016 (JP); HIROTA, Ryu, Itami-shi Hyogo 664-0016 (JP); FUJIWARA, Shinsuke, Itami-shi Hyogo 664-0016 (JP); TANAKA, Haruko, Itami-shi Hyogo 664-0016 (JP)
(74) Representative: Grünecker, Kinkeldey, Stockmair & Schwanhäusser Anwaltssozietät
(86) International application number: PCT/JP2008/066946
(87) International publication number: WO 2009/044639

(57) **Abstract**

A III-nitride crystal growth method that enables growing large-scale crystal under a liquid-phase technique is made available.

The present III-nitride crystal growth method is a method of growing III-nitride crystal (10) by a liquid-phase technique, and is provided with: a step of preparing a III-nitride crystal substrate (1) having the same chemical composition as the III-nitride crystal (10), and having a thickness of not less than 0.5 mm; and a step of contacting onto a major surface (1*m*) of the III-nitride crystal substrate (1) a solution in which a nitrogen-containing gas (5) is dissolved in a solvent (3) that includes a Group-III metal, to grow III-nitride crystal (10) onto the major surface (1*m*).

## Description

### Technical Field

The present invention relates to methods of growing Group III-nitride crystal by solution growth.

### Background Art

Group 111-nitride crystal is employed as wafers or similar substrates for a wide variety of semiconductor devices. For the sake of manufacturing the various semiconductor devices more efficiently, large-scale III-nitride crystal is being demanded of late.

Methods of growing III-nitride crystal include vapor-phase techniques such as hydride vapor-phase epitaxy (HVPE) and metalorganic chemical vapor deposition (MOCVD), and liquid-phase techniques such as solution growth and flux growth. Herein, compared with vapor-phase techniques, liquid-phase techniques are superior from an environmental protection aspect, because toxic gases are not employed in the crystal growth.

An example of a way of growing III-nitride crystal under such liquid-phase techniques is the method for growing GaN crystal by high-pressure solution growth that M. Bockowski, "Growth and Doping of GaN and AlN Single Crystals under High Nitrogen Pressure," Crystal Research & Technology, Vol. 36, Issue 8-10, 2001, pp. 771-787 (Non-Patent Document 1) discloses. Another example is the method for growing GaN crystal by an Na-flux technique that H. Yamane, et al., "Preparation of GaN Single Crystals Using a Na Flux," Chemistry of Materials, Vol. 9, No. 2, 1997, pp. 413-416 (Non-Patent Document 2) discloses. Likewise, Japanese Unexamined Pat. App. Pub. No. 2003-206198 (Patent Document 1) discloses an Na-flux based GaN crystal growth method in which a platelike III-nitride seed crystal is employed.

With the growth method disclosed in Non-Patent Document 1, however, the crystal-growth conditions are, at 1500 C° and 1 GPa, high-temperature, high-pressure, which therefore make the cost of manufacturing the crystal higher, and because the method does not employ a seed crystal it is prohibitive of growing large-scale crystal. With the growth method disclosed in Non-Patent Document 2, meanwhile, although the crystal-growth conditions are, at 800 C° and 10 MPa, relatively easy to implement, because the method does not employ a seed crystal it too is prohibitive of growing large-scale crystal. And with the growth method disclosed in Patent Document 1, the platelike seed crystal employed does not measure large enough across to yield large-scale crystal.
*Patent Document 1*:
   Japanese Unexamined Pat. App. Pub. No. 2003-206198.
*Non-Patent Document 1*:
   M. Bockowski, "Growth and Doping of GaN and AlN Single Crystals under High Nitrogen Pressure," Crystal Research & Technology, Vol. 36, Issue 8-10, 2001, pp. 771-787.
*Non-Patent Document 2*:
   H. Yamane, et al., "Preparation of GaN Single Crystals Using a Na Flux," Chemistry of Materials, Vol. 9, No. 2, 1997, pp. 413-416.

### Disclosure of Invention

### Problem Invention Is to Solve

If, however, in growing III-nitride crystal by liquid-phase techniques such as solution growth or flux growth, onto a large-diameter, platelike III-nitride crystal substrate III-nitride crystal whose chemical composition is the same as that of the substrate is homoepitaxially grown, cracking in the substrate and the III-nitride crystal grown onto the substrate will arise, which is prohibitive of obtaining large-scale III-nitride crystal substrates.

An object of the present invention is to make available a III-nitride crystal growth method that enables growing large-scale crystal under a liquid-phase technique.

As a result of investigating in detail the cause of cracking in such III-nitride crystal substrates and III-nitride crystal, a correlation between cracking in the substrates and III-nitride crystal, and the thickness of the substrates was discovered. Proceeding further with the investigations led to discovering that in the homoepitaxial growth of III-nitride crystal onto III-nitride crystal substrates by a liquid-phase technique, having the thickness of the III-nitride crystal substrate be not less than 0.5 mm, preferably not less than 0.67 mm, more preferably not less than 0.84 mm, and even more preferably not less than 1.0 mm, minimizes cracking in the III-nitride crystal substrate and the III-nitride crystal grown onto the substrate to enable the growth of large-scale III-nitride crystal.

### Means for Resolving the Problem

The present invention is a method of growing Group-III nitride crystal by a liquid-phase technique, the III-nitride crystal growth method being provided with: a step of preparing a III-nitride crystal substrate having the same chemical composition as the III-nitride crystal, and having a thickness of not less than 0.5 mm; and a step of contacting onto a major surface of the III-nitride crystal substrate a solution in which a nitrogen-containing gas is dissolved in a solvent that includes a Group-III metal, to grow III-nitride crystal onto the major surface.

In a III-nitride crystal growth method involving the present invention, the major surface of the III-nitride crystal substrate can have a surface area of 0.78 cm² or more. Furthermore, the solvent can be a Group-III metal having a purity of 99 mol% or greater. Likewise, the nitrogen-containing gas can be gaseous nitrogen having a purity of 99 mol% or greater.

### Effects of the Invention

According to the present invention, a III-nitride crystal growth method that under a liquid-phase technique minimizes occurrence of cracking to enable growing large-scale crystal is made available.

### Brief Description of Drawings

Fig. 1 is a simplified sectional view for illustrating one mode of embodying a III-nitride crystal growth method involving the present invention.
Fig. 2 is a graph plotting the relationship between substrate thickness and cracking incidence.

### Legend

1: III-nitride crystal substrate
1*m*: major surface
3: solvent
5: nitrogen-containing gas
10: III-nitride crystal
23: crystal-growth system

### Best Mode for Carrying Out the Invention

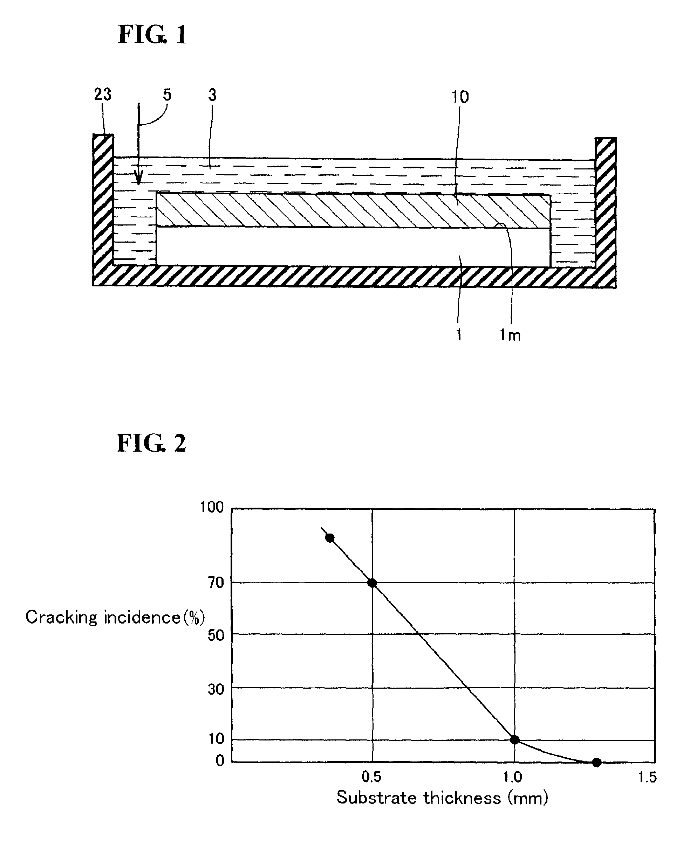

One mode of embodying a method, involving the present invention, of growing III-nitride crystal is, with reference to Fig. 1, a method of growing III-nitride crystal 10 by a liquid-phase technique, the III-nitride crystal growth method being provided with: a step of preparing a III-nitride crystal substrate 1 having the same chemical composition as the III-nitride crystal 10, and having a thickness of not less than 0.5 mm; and a step of contacting onto a major surface 1*m* of the III-nitride crystal substrate I a solution in which a nitrogen-containing gas 5 is dissolved in a solvent 3 that includes a Group-III metal, to grow III-nitride crystal 10 onto the major surface 1*m*.

With occurrence of cracking in a III-nitride crystal substrate and III-nitride crystal grown onto a major surface of the substrate being minimized by means of a III-nitride crystal growth method of the present embodying mode, large-scale III-nitride crystal is obtained.

A III-nitride crystal growth method of the present embodying mode is a method of growing III-nitride crystal 10 by a liquid-phase technique. Herein, "a liquid-phase technique" means a method of growing crystal in the liquid phase.

A III-nitride crystal growth method of the present embodying mode is provided with a step of preparing a III-nitride crystal substrate 1 having the same chemical composition as the III-nitride crystal 10 that is grown, and having a thickness of not less than 0.5 mm. Because the III-nitride crystal substrate 1 has the same chemical composition as the III-nitride crystal that is grown, onto a major surface 1*m* of the III-nitride crystal substrate 1, III-nitride crystal 10 can be homoepitaxially grown. In a case where Al*ₓ*Ga*_{y}*In_{1-*x*-*y*}N crystal (0 • •*x*; 0 • •*y*; *x* + *y*• •1) is grown homoepitaxially as the III-nitride crystal 10 for example, Al*ₓ*Ga*_{y}*In_{1-*x*-*y*}N crystal (0• •*x*; 0• •*y*; *x* + *y* • •1) may be utilized as the III-nitride crystal substrate 1.

Likewise, because the III-nitride crystal substrate 1 has a thickness of not less than 0.5 mm, occurrences of cracking due to stress arising between the III-nitride crystal substrate 1 and the III-nitride crystal 10 that is grown onto its major surface 1*m* can be controlled to a minimum thanks to the rigidity of the III-nitride crystal substrate 1. From a perspective thus, the III-nitride crystal substrate 1 preferably has a thickness of not less than 0.67 mm, more preferably has a thickness of not less than 0.84 mm, and still more preferably has a thickness of not less than 1.0 mm. On the other hand, owing to the expensiveness of III-nitride crystal substrates, from a cost perspective, substrates of lesser thickness are desirable; having a thickness of not greater than 2.0 mm, for example, is preferable.

Also, the surface area of the major surface 1*m* of the III-nitride crystal substrate 1, while not being particularly limited preferably is not less than 0.78 cm², more preferably not less than 5 cm², still more preferably not less than 20 cm². In growing III-nitride crystal 10 as set out in the present embodying mode, cracking in the III-nitride crystal substrate 1 and the III-nitride crystal 10 can be held in check even with the surface area of the major surface 1*m* of the III-nitride crystal 1 being large.

Herein, as long as the III-nitride crystal substrate 1 utilized in the present embodying mode has the same chemical composition as that of the III-nitride crystal 10 that is grown and has a thickness of not less than 0.5 mm, it is not particularly limited, and may be a substrate grown by a liquid-phase technique such as solution growth or flux growth, or may be a substrate grown by a vapor-phase technique such as hydride vapor-phase epitaxy (HVPE), metalorganic chemical vapor deposition (MOCVD), or molecular-beam epitaxy (MBE). From the perspective of ease of obtaining thick crystal, substrates grown by HVPE are preferable.

A III-nitride crystal growth method of the present embodying mode is provided with a step of contacting onto a major surface 1*m* of a III-nitride crystal substrate 1 a solution in which a nitrogen-containing gas 5 is dissolved into a solvent 3 including a Group-III metal, to grow III-nitride crystal 10 onto the major surface 1*m*. Furnishing a step thus of growing III-nitride crystal 10 makes it possible to minimize cracking in the III-nitride crystal substrate 1 and the III-nitride crystal 10 grown onto the substrate.

Such step of growing III-nitride crystal 10 is carried out, for example, in the following manner. To begin with, the III-nitride crystal substrate 1 is placed, with its major surface 1*m* facing upward, inside a crystal-growth vessel 23, which is then filled with the solvent 3 including the Group-III metal. The solvent 3 is solid while at room temperature (approximately 25°C), but by being heated later is liquefied.

Although the solvent 3 including the Group-III metal is not particularly limited, from a perspective of growing highly pure III-nitride crystal 10, Group-III metal of high purity is preferable. From a standpoint thus, a Group-III metal having a purity of 99 mol% or greater is preferable for the solvent 3, while a Group-III metal having a purity of 99.999 mol% or greater is further preferable. Herein, in instances in which the solvent 3 includes Group-III metal of two or more kinds, the purity of each of the Group-III metals is preferably not less than 99 mol%, more preferably not less than 99.999 mol%.

Further, although the amount of the Group-III metal-including solvent 3 that is put into the crystal-growth vessel 23 is not particularly limited, it is preferable that the depth of the liquefied solvent 3 (melt) be, from the surface of the solvent 3 to the major surface 1*m* of the III-nitride crystal substrate 1, not less than 1 mm but not more than 50 mm. This is because if the depth is less than 1 mm, the solvent 3 (melt) is liable not to cover the major surface 1*m* of the III-nitride crystal substrate 1, on account of the surface tension of the solvent 3, while if greater than 50 mm, the supply of nitrogen through the surface of the liquefied solvent 3 will fall short.

Next, the crystal-growth vessel 23 into which the III-nitride crystal substrate 1 and the solvent 3 including the Group-III metal have been placed is heated, the nitrogen-containing gas 5 is supplied into the solvent 3 inside the crystal-growth vessel 23, and the temperature inside the crystal-growth vessel 23 (crystal-growth temperature) is made 900°C to 1650°C, and the pressure of the nitrogen-containing gas inside the crystal-growth vessel 23 (crystal-growth pressure), 4 MPa to 980 MPa. In that state, the Group-III metal-including solvent 3 liquefies and the nitrogen-containing gas 5 dissolves into the liquefied solvent 3. In this way, a solution in which nitrogen-containing gas 5 has been dissolved into a Group-III metal-including solvent 3 can be contacted onto a major surface 1*m* of the III-nitride crystal substrate 1, to grow III-nitride crystal 10 onto the major surface 1*m*.

Although there are no particular limitations on the nitrogen-containing gas 5, from a perspective of growing highly pure III-nitride crystal 10, gaseous nitrogen having a purity of 99 mol% or greater is preferable, with gaseous nitrogen having a purity of 99.999 mol% or greater being further preferable.

Next, after III-nitride crystal 10 has been grown, the temperature and pressure inside the crystal-growth vessel 23 are lowered to bring them to room temperature and atmospheric pressure, after which the III-nitride crystal 10 that has been grown onto the III-nitride crystal substrate 1 is taken out of the solvent 3. Despite stress acting between the III-nitride crystal substrate 1 and the III-nitride crystal 10 during the crystal growth and afterwards when the temperature and pressure inside the crystal-growth vessel 23 are lowered, the rigidity of the III-nitride crystal substrate 1 having a thickness of not less than 0.5 mm minimizes the occurrence of cracks in the III-nitride crystal substrate 1 and the III-nitride crystal 10.

### Embodiments

### Embodiment 1

Reference is made to Fig. 1: For the III-nitride crystal 1, a GaN substrate of 2 inch (5.08 cm) diameter and 0.5 mm thickness was prepared, wherein GaN bulk crystal grown by HVPE was sliced parallel to the (0001) plane, and a major surface 1*m* (the (0001) face) thereof was pol ished. The surface area of the major surface 1*m* of the GaN substrate was 20 cm².

Next, the GaN substrate (III-nitride crystal substrate 1), and metallic Ga of 99.9999 mol% purity (solvent 3) were placed inside the crystal-growth vessel 23. After that the crystal-growth vessel 23 was pumped down to a vacuum (vacuum level: 1 × 10⁻³ Pa).

Next, nitrogen gas of 99.99999 mol% purity (nitrogen-containing gas 5) was supplied into the crystal-growth vessel 23 interior in such a way that the pressure of the crystal-growth vessel interior would be 1 MPa. Subsequently, the crystal-growth vessel 23 was heated, and the temperature of the crystal-growth vessel 23 interior was ramped up to 950°C. In that state, the metallic Ga liquefied, forming a Ga melt (solvent 3), with the depth of the Ga melt (solvent 3) being 5 mm from the surface of the melt to the major surface 1*m* of the GaN substrate.

Next, with the temperature inside the crystal-growth vessel 23 being maintained at 950°C, the nitrogen gas of 99.99999 mol% purity (nitrogen-containing gas 5) was further supplied into the crystal-growth vessel 23 interior, to raise the pressure of the crystal-growth vessel interior to 10 MPa. In that state, the nitrogen gas (nitrogen-containing gas 5) dissolved into the Ga melt (solvent 3), whereby the solution for contacting the major surface of the GaN substrate was formed.

Next, at a crystal-growth temperature (temperature of the crystal-growth vessel interior during crystal growth) of 950°C, and a crystal-growth pressure (pressure of the crystal-growth vessel interior during crystal growth) of 10 MPa, GaN crystal (III-nitride crystal 10) was grown to 0.5 mm thickness onto the major surface 1*m* of the GaN substrate.

Such GaN crystal growth was carried out ten times, and in the 10 samples made up of GaN substrates and Ga crystal, the proportion of the samples in which cracks occurred in at least either the GaN substrate or the GaN crystal was calculated as the cracking incidence (%). The cracking incidence in Embodiment 1 was 70%. Therein, the cracking incidence being not greater than 70% allows the minimum reproducibility necessary for manufacturing to be guaranteed, making it possible to manufacture GaN crystal by the present manufacturing method. The results are tabulated in Table I.

### Embodiment 2

With the exception that a GaN substrate (III-nitride crystal substrate 1) of 1.0 mm thickness was utilized, growth of GaN crystal (III-nitride crystal 10) was carried out in the same manner as in Embodiment 1. In Embodiment 2 the cracking incidence could be reduced to an extremely low 10%. The results are tabulated in Table I.

### Embodiment 3

With the exception that a GaN substrate (III-nitride crystal substrate 1) of 1.3 mm thickness was utilized, growth of GaN crystal (III-nitride crystal 10) was carried out in the same manner as in Embodiment 1. In Embodiment 3 it was possible to curtail occurrence of cracking completely, in that the cracking incidence was 0%. The results are tabulated in Table I.

### Comparative Example 1

With the exception that a GaN substrate (III-nitride crystal substrate 1) of 0.35 mm thickness was employed, growth of GaN crystal (III-nitride crystal 10) was carried out in the same manner as in Embodiment 1. In Comparative Example 1 the cracking incidence was a high 90%. The results are tabulated in Table I. Further, the relationship between substrate thickness and cracking incidence is graphed in Fig. 2.

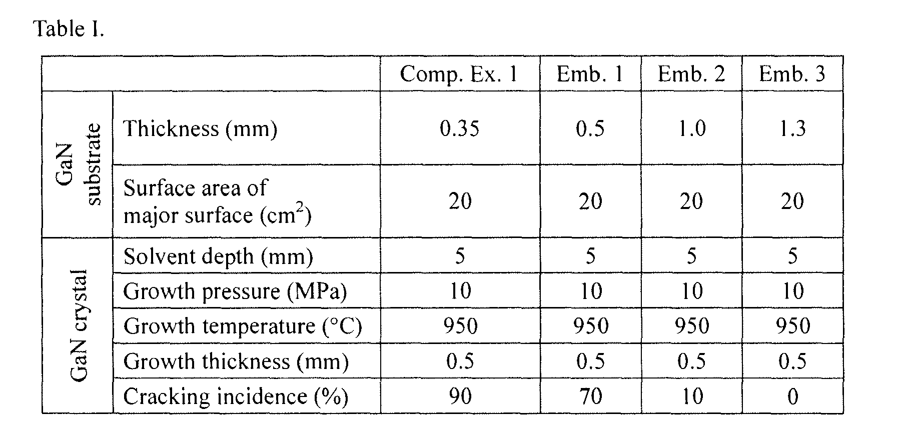

As is evident from Table I, it was possible to grow, by a liquid-phase technique, GaN crystal (III-nitride crystal 10) onto a major surface of a GaN substrate (III-nitride crystal substrate 1) having a thickness of 0.5 mm, at a cracking incidence of not greater than 70%. And as is evident from Fig. 2, it will be appreciated that in order to make the cracking incidence be not greater than 70%, a GaN substrate of not less than 0.5 mm thickness is necessary; in order to make the cracking incidence be not greater than 50%, a GaN substrate of not less than 0.67 mm is necessary; in order to make the cracking incidence be not greater than 30%, a GaN substrate of not less than 0.84 mm is necessary; and in order to make the cracking incidence be not greater than 10%, a GaN substrate of not less than 1.0 mm is necessary. Accordingly, it will be understood that the thickness of the III-nitride crystal substrate must be not less than 0.5 mm, and preferably is not less than 0.67 mm, more preferably not less than 0.84 mm, and still more preferably not less than 1.0 mm.

### Embodiment 4

With the exception that a GaN substrate (III-nitride crystal substrate 1) of 1.0 cm diameter was utilized, growth of GaN crystal (III-nitride crystal 10) was carried out in the same manner as in Embodiment 2. In this case, the surface area of the major surface of the GaN substrate utilized in Embodiment 4 was 0.78 cm². In Embodiment 4 the cracking incidence could be reduced to an extremely low 10%. The results are tabulated in Table II.

### Embodiment 5

With the exception that a GaN substrate (III-nitride crystal substrate 1) of 1.8 cm diameter was utilized, growth of GaN crystal (III-nitride crystal 10) was carried out in the same manner as in Embodiment 2. In this case, the surface area of the major surface of the GaN substrate utilized in Embodiment 5 was 2.54 cm². In Embodiment 5 the cracking incidence could be reduced to an extremely low 10%. The results are tabulated in Table II.

### Embodiment 6

With the exception that a GaN substrate (III-nitride crystal substrate 1) of 1 inch (2.54 cm) diameter was utilized, growth of GaN crystal (III-nitride crystal 10) was carried out in the same manner as in Embodiment 2. In this case, the surface area of the major surface of the GaN substrate utilized in Embodiment 6 was 5 cm². In Embodiment 6 the cracking incidence could be reduced to an extremely low 10%. The results are tabulated in Table II. It should be noted that in Table II, for the sake of comparison Embodiment 2 has also been included in the tabulation.

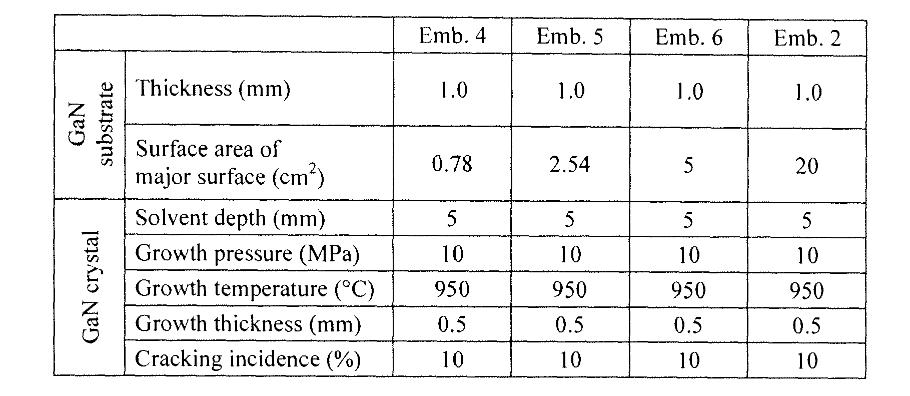

As is evident from Table II, it will be understood that if the thickness of the GaN substrates (III-nitride crystal substrates 1) is the same, the same cracking incidence will be obtained even though the surface areas of the GaN substrate major surfaces differ. In short, it will be appreciated that large III-nitride crystal can be grown at a low cracking incidence by utilizing a III-nitride crystal substrate whose thickness is not less than 0.5 mm and whose major-surface surface area is large.

### Embodiment 7

With the exception that the GaN crystal (III-nitride crystal 10) was grown to 0.01 mm thickness, growth of GaN crystal (III-nitride crystal 10) was carried out in the same manner as in Embodiment 2. In Embodiment 7 the cracking incidence could be reduced to an extremely low 10%. The results are tabulated in Table III.

### Embodiment 8

With the exception that the GaN crystal (III-nitride crystal 10) was grown to 1.0 mm thickness, growth of GaN crystal (III-nitride crystal 10) was carried out in the same manner as in Embodiment 2. In Embodiment 8 the cracking incidence could be reduced to an extremely low 10%. The results are tabulated in Table III.

### Embodiment 9

With the exception that the GaN crystal (III-nitride crystal 10) was grown to 2.0 mm thickness, growth of GaN crystal (III-nitride crystal 10) was carried out in the same manner as in Embodiment 2. In Embodiment 9 the cracking incidence could be reduced to an extremely low 10%. The results are tabulated in Table III. It should be noted that in Table III, for the sake of comparison Embodiment 2 has also been included in the tabulation.

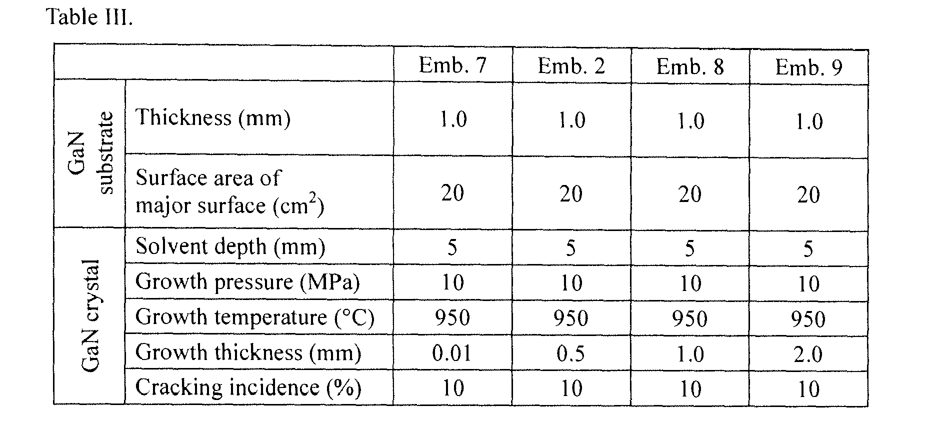

As is evident from Table III, it will be understood that if the thickness of the GaN substrates (III-nitride crystal substrates 1) is the same, the same cracking incidence will be obtained even though the thicknesses of the grown GaN crystal differ. In sum, it will be appreciated that III-nitride crystal of various thicknesses can be grown at a low cracking incidence by utilizing a III-nitride crystal substrate whose thickness is not less than 0.5 mm and whose major-surface surface area is large.

### Embodiment 10

With the exception of having the crystal-growth temperature be 900°C and the crystal-growth pressure be 4 MPa when the GaN crystal (III-nitride crystal 10) was grown, growth of GaN crystal (III-nitride crystal 10) was carried out in the same manner as in Embodiment 2. In Embodiment 10 the cracking incidence could be reduced to an extremely low 10%. The results are tabulated in Table IV.

### Embodiment 11

With the exception of having the crystal-growth temperature be 1150°C and the crystal-growth pressure be 196 MPa when the GaN crystal (III-nitride crystal 10) was grown, growth of GaN crystal (III-nitride crystal 10) was carried out in the same manner as in Embodiment 2. In Embodiment 11 the cracking incidence could be reduced to an extremely low 10%. The results are tabulated in Table IV.

### Embodiment 12

With the exception of having the crystal-growth temperature be 1650°C and the crystal-growth pressure be 980 MPa when the GaN crystal (III-nitride crystal 10) was grown, growth of GaN crystal (III-nitride crystal 10) was carried out in the same manner as in Embodiment 2. In Embodiment 12 the cracking incidence could be reduced to an extremely low 10%. The results are tabulated in Table IV. It should be noted that in Table IV, for the sake of comparison Embodiment 2 has also been included in the tabulation.

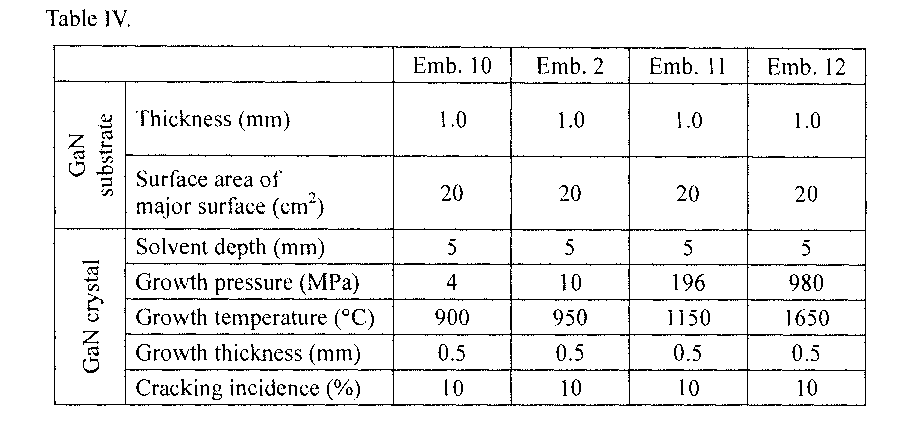

As is evident from Table IV, it will be understood that if the thickness of the GaN substrates (III-nitride crystal substrates 1) is the same, the same cracking incidence will be obtained even though the conditions under which the GaN crystal is grown differ. In sum, it will be appreciated that III-nitride crystal can be grown at a low cracking incidence under various crystal-growth conditions by utilizing a III-nitride crystal substrate whose thickness is not less than 0.5 mm and whose major-surface surface area is large.

The presently disclosed embodying modes and embodiment examples should in all respects be considered to be illustrative and not limiting. The scope of the present invention is set forth not by the foregoing description but by the scope of the claims, and is intended to include meanings equivalent to the scope of the claims and all modifications within the scope.

### Industrial Applicability

Group-III nitride crystal obtained by a growth method involving the present invention is utilized as substrates for devices including optical elements such as light-emitting diodes and laser diodes; semiconductor electronic devices such as rectifiers, bipolar transistors, field-effect transistors, and high electron mobility transistors (HEMTs); semiconductor sensors such as temperature sensors, pressure sensors, radiation sensors, and visible-blind ultraviolet detectors; and surface acoustic wave devices (SAW devices), vibrators, resonators, oscillators, microelectromechanical system (MEMS) parts, and piezoelectric actuators.

## Claims

1. A method of growing Group-III nitride crystal by a liquid-phase technique, the III-nitride crystal growth method comprising:
a step of preparing a III-nitride crystal substrate having the same chemical composition as the III-nitride crystal, and having a thickness of not less than 0.5 mm; and
a step of contacting onto a major surface of the III-nitride crystal substrate a solution in which a nitrogen-containing gas is dissolved in a solvent that includes a Group-III metal, to grow III-nitride crystal onto the major surface.

2. The III-nitride crystal growth method set forth in claim 1, wherein said major surface has a surface area of 0.78 cm² or more.

3. The III-nitride crystal growth method set forth in claim 1 or claim 2, wherein said solvent is a Group-III metal having a purity of 99 mol% or greater.

4. The III-nitride crystal growth method set forth in any of claims 1 through 3, wherein said nitrogen-containing gas is gaseous nitrogen having a purity of 99 mol% or greater.
